# EUROPEAN PATENT APPLICATION

(11) **EP 4 648 560 A2**
(43) Date of publication of application: **12.11.2025**
(21) Application number: 24738497.7
(22) Date of filing: 03.01.2024
(51) Int. Cl.: H05K 7/20

(54) **OUTDOOR CABINET TEMPERATURE CONTROL SYSTEM, METHOD THEREFOR, AND STORAGE MEDIUM THEREFOR**

(30) Priority: 03.01.2023 CN 202310004011
(71) Applicant: China Mobile Energy Technology Beijing Co. Ltd., Beijing 100085 (CN); China Mobile Group Design Institute Co., Ltd., Beijing 100080 (CN); CHINA MOBILE COMMUNICATIONS GROUP CO., LTD., Beijing 100032 (CN)
(72) Inventor: LI, Yusheng, Beijing 100080 (CN); LIU, Baochang, Beijing 100080 (CN); ZHAO, Xiaodan, Beijing 100080 (CN); WANG, Wei, Beijing 100080 (CN); ZHENG, Hong, Beijing 100080 (CN); ZHAO, Hepeng, Beijing 100080 (CN); CHENG, Lei, Beijing 100080 (CN); LUO, Yongqiang, Beijing 100080 (CN); ZHANG, Yu, Beijing 100080 (CN); HE, Qian, Beijing 100080 (CN); ZHAO, Han, Beijing 100080 (CN); LIU, Qiang, Beijing 100080 (CN)
(74) Representative: Maiwald GmbH
(86) International application number: PCT/CN2024/070416
(87) International publication number: WO 2024/146564

(57) **Abstract**

The invention discloses an outdoor cabinet temperature control system, a method therefor, and a storage medium therefor. The method comprises: when a target module in a temperature control system is operating and when the output air temperature of an equipment compartment is less than a preset temperature threshold value, the rotating speed of a fan in the target module is reduced, and when the output air temperature is equal to a preset temperature threshold value, the first operating power of the temperature control system is obtained: the target module is controlled to be turned off, a refrigeration module is controlled to be started, and when the output air temperature is equal to a preset temperature threshold value, a second operating power of the temperature control system is obtained:, and the operation of the target module and the refrigeration module are controlled according to the first operating power and the second operating power, The present invention reduces the energy consumption of the temperature control system while achieving temperature control on the equipment compartment.

## Description

### CROSS-REFERENCE TO RELATED APPLICATIONS

This application is based on and claims priority to Chinese patent application NO. 202310004011.6, filed on January 3, 2023, the entire contents of which are incorporated herein by reference.

### TECHNICAL FIELD

The disclosure relates to the field of computer technology and, in particular to a system and a method for temperature control of an outdoor cabinet, and a storage medium.

### BACKGROUND

With the large number of communication base stations deployed, outdoor cabinet-type base stations may become the development trend for future base station construction due to their low construction costs, short construction periods, and low operating costs. Further, as the communication traffic increases, power consumption of the device increases. For example, the power consumption of a 5G device reaches 3 to 4 times that of a 4G device. Consequently, after the concentrated deployment of 5G devices, the heat density of the cabinets may be sharply increased.

A current system for temperature control of an outdoor cabinet is generally in the form of cabinet door air conditioner, having a single form, which is prone to frequent failures, thus it cannot meet the dissipation demands for the high power consumption and high heat of the 5G device. To maintain the temperature of the device within a normal operating temperature range, the traditional temperature control method may constantly increase the number of cabinet door air conditioners and cooling capacity of the air conditioners, and constantly lower a set temperature of the air conditioners. This causes the cabinet air conditioner to operate continuously for a long time, resulting in excessive energy consumption.

### SUMMARY

A main purpose of the disclosure is to provide a system and a method for temperature control of an outdoor cabinet, and a storage medium, to solve a problem of how to reduce energy consumption of the system for temperature control of an outdoor cabinet.

To realize the above purpose, a method for temperature control of an outdoor cabinet is provided in the disclosure. The method includes: reducing a rotational speed of a fan in a target module in a temperature control system in response to the target module in the temperature control system operating and an air outlet temperature of an equipment compartment being less than a preset temperature threshold; and obtaining a first operating power of the temperature control system in response to the air outlet temperature being equal to the preset temperature threshold;
turning off the target module and turning on a refrigeration module, and obtaining a second operating power of the temperature control system in response to the air outlet temperature being equal to the preset temperature threshold; and
controlling operation of the target module and the refrigeration module based on the first operating power and the second operating power.

Optionally, controlling the operation of the target module and the refrigeration module based on the first operating power and the second operating power includes: controlling the refrigeration module to continue operating in response to the first operating power being greater than or equal to the second operating power; and turning off the refrigeration module and turning on the target module in response to the first operating power being less than the second operating power.

Optionally, the method further includes:
turning on the refrigeration module in response to the target module in the temperature control system operating and the air outlet temperature being greater than or equal to the preset temperature threshold;
obtaining a third operating power of the temperature control system in response to the air outlet temperature being equal to the preset temperature threshold;
turning off the target module, and obtaining a fourth operating power of the temperature control system in response to the air outlet temperature being again equal to the preset temperature threshold; and
controlling the operation of the target module and the refrigeration module based on the third operating power and the fourth operating power.

Optionally, controlling the operation of the target module and the refrigeration module based on the third operating power and the fourth operating power includes:
turning on both the target module and the refrigeration module in response to the third operating power being less than the fourth operating power; and
controlling the refrigeration module to continue operating in response to the third operating power being greater than or equal to the fourth operating power.

To realize the above purpose, a system for temperature control of an outdoor cabinet is provided in the disclosure. The system includes:
an equipment compartment; and
a temperature control compartment, in which the temperature control compartment includes a control module and a temperature control module, the control module is configured to control operation of the temperature control module based on a power of the temperature control module, and the temperature control module includes a refrigeration module, a fresh air module, a heat exchange module and a heating module; the control module includes a processor, a memory, and a program for temperature control of an outdoor cabinet executable by the processor, when the program is executed by the processor, steps of any above methods are implemented.

Optionally, the refrigeration module, the fresh air module, the heat exchange module and the heating module are arranged at intervals, and each in the temperature control module is connected to the equipment compartment respectively.

Optionally, the refrigeration module includes an outdoor unit and an indoor unit arranged independently with each other, in which an air inlet and an air outlet of the indoor unit are connected to the equipment compartment, and an air inlet and an air outlet of the outdoor unit are connected to external environment.

Optionally, the fresh air module includes a first air inlet compartment and a first air outlet compartment arranged independently, in which an air inlet of the first air inlet compartment is connected to the external environment and is equipped with an air inlet fan, and an air outlet of the first air inlet compartment is connected to the equipment compartment; in which an air inlet of the first air outlet compartment is connected to the equipment compartment, and an air outlet of the first air outlet compartment is connected to the external environment and is equipped with an air outlet fan.

Optionally, the heat exchange module includes a second air inlet compartment and a second air outlet compartment, in which a heat exchanger is arranged between the second air inlet compartment and the second air outlet compartment, an air inlet and an air outlet of the second air inlet compartment are connected to the equipment compartment respectively, and an air inlet and an air outlet of the second air outlet compartment are connected to the external environment.

Optionally, the heating module includes a third air inlet compartment and a third air outlet compartment, in which an electric heater is arranged between the third air inlet compartment and the third air outlet compartment; the third air inlet compartment is equipped with an air inlet fan, and an air inlet of the third air inlet compartment is connected to the equipment compartment; in which an air outlet of the third air outlet compartment is connected to the equipment compartment, and the third air outlet compartment is equipped with an air outlet fan.

To realize the above purpose, a computer-readable storage medium is provided in the disclosure. The computer-readable storage medium stores a program for temperature control of an outdoor cabinet that, when executed by a processor, implements steps of the above methods.

With the system and the method for temperature control of an outdoor cabinet, and the storage medium provided in the disclosure, the rotational speed of the fan in the target module in the temperature control system is reduced when the target module in the temperature control system operates and the air outlet temperature of the equipment compartment is less than the preset temperature threshold, the first operating power of the temperature control system is obtained when the air outlet temperature is equal to the preset temperature threshold, the target module is turned off and the refrigeration module is turned on, the second operating power of the temperature control system is obtained when the air outlet temperature is equal to the preset temperature threshold, and the operation of the target module and the refrigeration module are controlled based on the first operating power and the second operating power. By obtaining the first operating power of the temperature control system when the target module operates, and the second operating power when the refrigeration module operates, and comparing the first operating power and the second operating power, the operation of the target module and the refrigeration module are controlled based on the comparison result. Thus, the temperature control of the equipment compartment is realized, the energy consumption of the temperature control system is reduced.

### BRIEF DESCRIPTION OF THE DRAWINGS

FIG. 1 is a block diagram illustrating a system for temperature control of an outdoor cabinet according to an embodiment of the disclosure.
FIG. 2 is a block diagram illustrating a hardware architecture of a control module of a system for temperature control of an outdoor cabinet according to an embodiment of the disclosure.
FIG. 3 is a top view schematic diagram of a system for temperature control of an outdoor cabinet according to an embodiment of the disclosure.
FIG. 4 is a block diagram illustrating a refrigeration module of a system for temperature control of an outdoor cabinet according to an embodiment of the disclosure.
FIG. 5 is a block diagram illustrating a fresh air module of a system for temperature control of an outdoor cabinet according to an embodiment the disclosure.
FIG. 6 is a block diagram illustrating a heat exchange module of a system for temperature control of an outdoor cabinet according to an embodiment the disclosure.
FIG. 7 is a block diagram illustrating a heating module of a system for temperature control of an outdoor cabinet according to an embodiment of the disclosure.
FIG. 8 is a flow chart illustrating a method for temperature control of an outdoor cabinet according to an embodiment of the disclosure.
FIG. 9 is a flow chart illustrating a method for temperature control of an outdoor cabinet according to an embodiment of the disclosure.
FIG. 10 is a flow chart illustrating a method for temperature control of an outdoor cabinet according to an embodiment of the disclosure.
FIG. 11 is a flow chart illustrating a method for temperature control of an outdoor cabinet according to an embodiment of the disclosure.

The implementation of the purpose, functional features and advantages of the present invention will be further described in conjunction with the embodiments and with reference to the accompanying drawings.

### DETAILED DESCRIPTION

It should be understood that the specific embodiments described herein are used only to explain the invention and are not intended to limit the invention.

The solution of embodiments of the disclosure includes: reducing a rotational speed of a fan in a target module in a temperature control system in response to the target module in the temperature control system operating and an air outlet temperature of an equipment compartment being less than a preset temperature threshold, and obtaining a first operating power of the temperature control system in response to the air outlet temperature being equal to the preset temperature threshold; turning off the target module and turning on a refrigeration module, and obtaining a second operating power of the temperature control system in response to the air outlet temperature being equal to the preset temperature threshold; and controlling operation of the target module and the refrigeration module based on the first operating power and the second operating power. By obtaining the first operating power of the temperature control system when the target module operates and the second operating power when the refrigeration module operates, and comparing the first operating power and the second operating power, the operation of the target module and the refrigeration module is controlled based on the comparison result. Thus, while the temperature control of the equipment compartment is realized, and the energy consumption of the temperature control system is reduced.

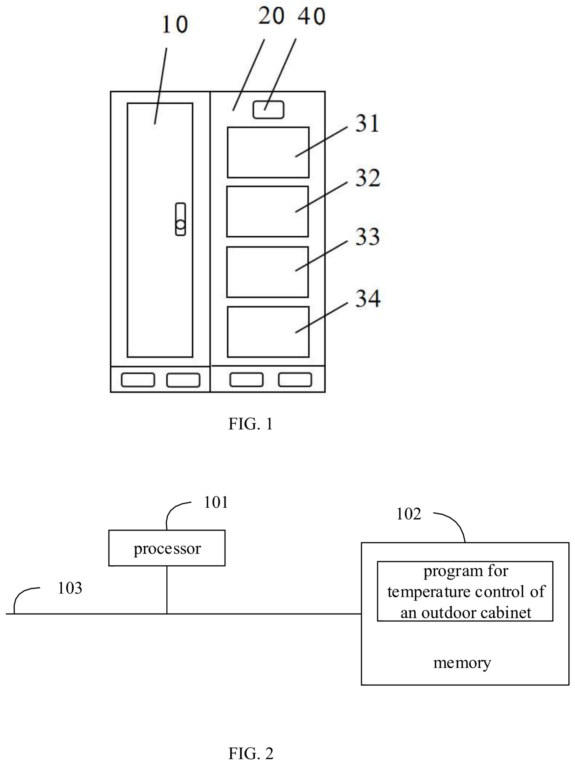

Referring to FIG. 1, a system for temperature control of an outdoor cabinet is provided in the disclosure. The system includes: an equipment compartment 10 and a temperature control compartment 20.

The temperature control compartment 20 includes a control module 40 and a temperature control module. The control module 40 is configured to control operation of the temperature control module based on a power of the temperature control module, and the temperature control module includes a refrigeration module, a fresh air module, a heat exchange module and a heating module.

The control module 40 includes a processor, a memory, and a program for temperature control of an outdoor cabinet executable by the processor. When the program is executed by the processor, steps of the method are implemented.

Optionally, the control module 40 can perform current and voltage monitoring, record an operating power P of the temperature control system in real time, and perform energy consumption assessment under different operating conditions based on this.

In an implementation, the control module 40 may be as shown in FIG. 2. The control module 40 includes: a processor 101, such as a central processing unit (CPU), a memory 102, and a communication bus 103. The communication bus 103 is configured to implement the connection communication between the components.

The memory 102 may be a high-speed random-access memory (RAM) memory or a non-volatile memory, such as a disk memory. As shown in FIG. 2, the memory 102, as a computer-readable storage medium, may include a program for temperature control of an outdoor cabinet. The processor 101 may be configured to call the program for temperature control of an outdoor cabinet stored in the memory 102 and implement the specific operation steps of a method for temperature control of an outdoor cabinet.

Optionally, the temperature control compartment 20 includes a plurality of temperature control modules. For example, the temperature control compartment 20 includes four temperature control modules, i.e., a temperature control module 31, a temperature control module 32, a temperature control module 33, and a temperature control module 34. The temperature control module may be any one of a refrigeration module, a fresh air module, a heat exchange module or a heating module. For example, the temperature control compartment includes four temperature control modules, in which the temperature control module 31 is a refrigeration module, the temperature control module 32 is a fresh air module, the temperature control module 33 is a heat exchange module, and the temperature control module 34 is a heating module.

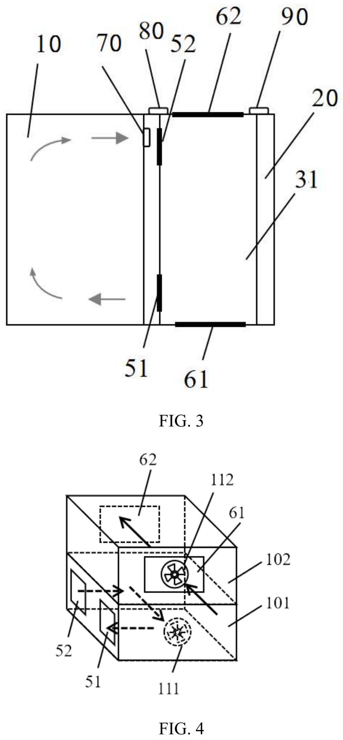

Optionally, when the temperature control compartment 20 includes the refrigeration module, the fresh air module, the heat exchange module and the heating module, the refrigeration module, the fresh air module, the heat exchange module and the heating module are arranged at intervals, and the temperature control modules are connected to the equipment compartment 10 respectively. Referring to FIG. 3, it is a top view diagram of the outdoor cabinet. An equipment temperature monitoring module 70 can monitor an air outlet temperature Te of the equipment compartment. An outdoor temperature monitoring module 80 can monitor an outdoor air temperature Ta. An air quality monitoring module 90 is configured to monitor an outdoor air quality. Each temperature control module is equipped with an inner supply air inlet 51 and an inner return air inlet 52 on the equipment side, and an outer air inlet 61 and an outer air outlet 62 on the environment side.

Optionally, the refrigeration module includes an outdoor unit and an indoor unit arranged independently with each other. The air outlet, i.e., the inner supply air inlet 51, and the air inlet, i.e., the inner return air inlet 52, of the indoor unit are connected to the equipment compartment 10. An air inlet, i.e., the outer air inlet 61, and an air outlet, i.e., the outer air outlet 62, of the outdoor unit are connected to external environment. Optionally, referring to FIG. 4, compartment 101 is an indoor unit, compartment 102 is an outdoor unit, and compartment 101 is not interconnected with compartment 102. Fan 111 is an inner fan, and fan 112 is an outer fan. The indoor unit supplies cold air into the equipment compartment 10 through the inner supply air inlet 51, and hot air in the equipment compartment 10 flows back through the inner return air inlet 52. A direction of airflow in the equipment compartment 10 is shown in FIG. 3. The cold air from the outdoor environment flows in through the outer air inlet 61, and after being heated by the outdoor unit, the hot air flows out through the outer air outlet 62.

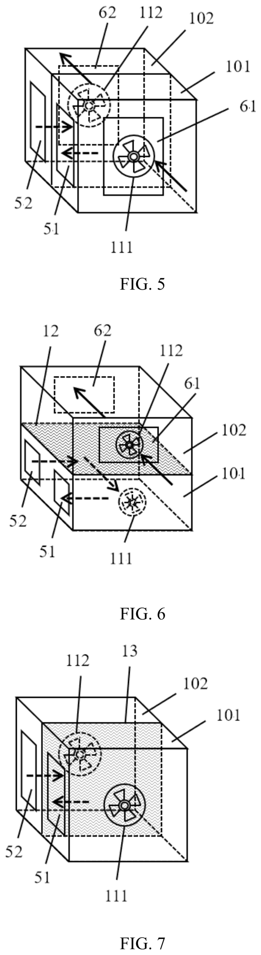

Optionally, the fresh air module includes a first air inlet compartment and a first air outlet compartment arranged independently. An air inlet of the first air inlet compartment, i.e., the outer air inlet 61, is connected to the external environment and is equipped with an air inlet fan. An air outlet of the first air inlet compartment, i.e. the inner supply air inlet 51, is connected to the equipment compartment 10. An air inlet of the first air outlet compartment, i.e. the inner return air inlet 52, is connected to the equipment compartment 10. An air outlet of the first air outlet compartment, i.e. the outer air outlet 62, is connected to the external environment and is equipped with an air outlet fan. Optionally, referring to FIG. 5, the fresh air module includes a fan and a filter device. The first air inlet compartment 101 is not interconnected with the first air outlet compartment 102. The compartment 101 is equipped with a filter. The fan 111 is an air inlet fan, and the fan 112 is an air exhaust fan. The outdoor cold air enters through the outer air inlet 61, flows through the filter, and is then delivered into the equipment compartment 10 through the inner supply air inlet 51. The hot air in the equipment compartment 10 flows through the inner return air inlet 52, and finally flows out through the outer air outlet 62.

Optionally, the heat exchange module includes a second air inlet compartment and a second air outlet compartment. A heat exchanger is arranged between the second air inlet compartment and the second air outlet compartment. An air outlet, i.e., the inner supply air inlet 51, and an air inlet, i.e., the inner return air inlet 52, of the second air inlet compartment are connected to the equipment compartment 10 respectively. An air inlet, i.e. the outer air inlet 61, and an air outlet, i.e. the outer air outlet 62, of the second air outlet compartment are connected to the external environment. Optionally, referring to FIG. 6, the heat exchange module includes a heat exchanger and fans. An air-to-air heat exchanger is arranged between the second air inlet compartment 101 and the second air outlet compartment 102. The compartment 101 and the compartment 102 are not interconnected. The fan 111 is an inner fan and the fan 112 is an outer fan. The outdoor cold air flows into the outer compartment through the outer air inlet 61, to cool the air and the air-to-air heat exchanger 12, and the hot air flows out through the outer air outlet 62. The hot air in the equipment compartment 10 flows into the inner compartment through the inner return air inlet 52, and after being cooled by the air and the air-to-air heat exchanger 12, the cold air is delivered into the equipment compartment 10 through the inner supply air inlet 51.

Optionally, the heating module includes a third air inlet compartment and a third air outlet compartment. An electric heater is arranged between the third air inlet compartment and the third air outlet compartment. The third air inlet compartment is equipped with an air inlet fan. An air inlet, i.e. the inner return air inlet 52, of the third air inlet compartment is connected to the equipment compartment. An air outlet, i.e. the inner supply air inlet 51, of the third air outlet compartment is connected to the equipment compartment. The third air outlet compartment is equipped with an air outlet fan. Optionally, referring to FIG. 7, the heating module includes an electric heater and fans. The third air inlet compartment 102 is interconnected with the third air outlet compartment 101, and is not equipped with an outer air inlet or an outer air outlet. The fan 111 is a supply air fan and the fan 112 is a return air fan. The air in the equipment compartment 10 flows into the compartment 101 through the inner return air inlet 52. After being heated by the electric heater 13, the hot air is sent into the equipment compartment 10 through the inner supply air inlet 51.

In the technical solution of the embodiments, the control module controls the air or the temperature in the equipment compartment by controlling the temperature control modules, to make the devices in the outdoor cabinet operate at a suitable environmental temperature, thus preventing device failures caused by excessively high or low temperatures. The safety of the device operation is improved. In addition, the operation of the temperature control module is controlled based on the power of the temperature control module, which realizes the temperature control of the equipment compartment and reduces the energy consumption of the temperature control system.

This solution can realize energy saving by flexibly combining temperature control modules in various scenarios. The temperature control system adopts a modularized architecture, combining temperature control modules with different functions, thus flexible combination can be made for different scenarios. In hot areas, a plurality of refrigeration modules can be turned on to ensure sufficient refrigeration capacity of the devices. In areas with abundant natural cooling sources and good air quality, the fresh air module can be turned on to utilize the natural refrigeration source to dissipate heat and reduce the energy consumption of the temperature control system. In areas with abundant natural cooling sources and poor air quality, the heat exchange module can be turned on for indirect heat exchange between the interior and exterior of the cabinet to reduce the energy consumption of the temperature control system. In cold areas, the heating module can be turned on to maintain the normal operating temperature of the devices. The switching between the modules can be automatically managed according to the control logic defined in this solution.

Based on the hardware architecture of the control module of the system for temperature control of an outdoor cabinet described above, the method for temperature control of an outdoor cabinet is provided in embodiments of the disclosure.

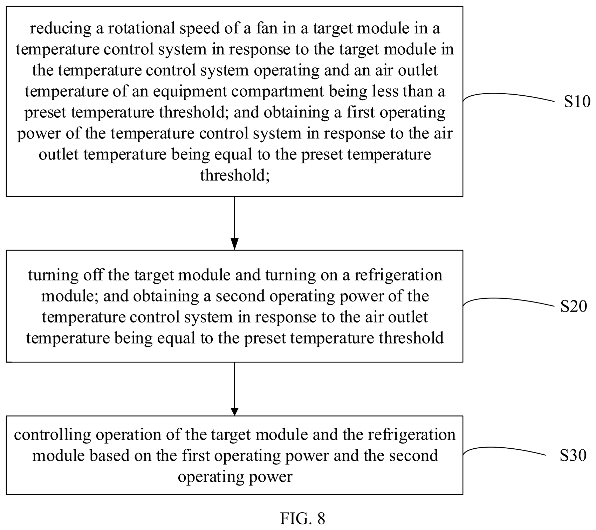

Referring to FIG. 8, it is a first embodiment of a method for temperature control of an outdoor cabinet of the disclosure. The method includes the following steps.

At step S10, a rotational speed of a fan in a target module in a temperature control system is reduced in response to the target module in the temperature control system operating and an air outlet temperature of an equipment compartment being less than a preset temperature threshold; and a first operating power of the temperature control system is obtained in response to the air outlet temperature being equal to the preset temperature threshold.

Optionally, the target module may be a fresh air module or a heat exchange module.

Optionally, the air outlet temperature of the equipment compartment may be collected by an equipment temperature monitoring module arranged at an air outlet. The equipment temperature monitoring module may be a temperature detection sensor.

The rotational speed of the fan in the target module is reduced when the target module in the temperature control system operates and the air outlet temperature of the equipment compartment is less than the preset temperature threshold. The fan may be an air inlet fan and/or an air outlet fan.

After reducing the rotational speed of the fan in the target module, the air outlet temperature gradually increases. When the air outlet temperature is equal to the preset temperature threshold, the first operating power for a current operation of the temperature control system is obtained. The first operating power is the operating power of the target module.

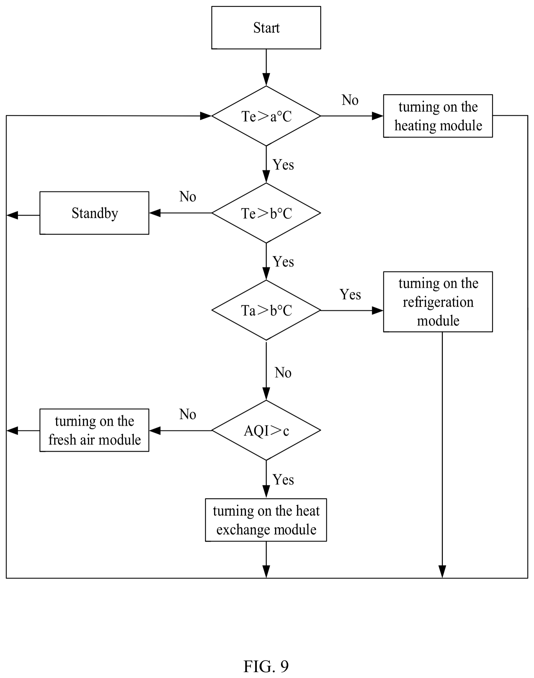

Optionally, before step S10, as shown in FIG. 9, the method further includes: detecting an air outlet temperature Te of the equipment compartment when the temperature control system is detected to be started; turning on the heating module when the air outlet temperature Te is less than or equal to a preset first temperature threshold a°C; obtaining an outdoor temperature of the temperature control system when the air outlet temperature Te is greater than a preset second temperature threshold b°C; detecting an air quality index (AQI) when the outdoor temperature Ta is less than or equal to the preset second temperature threshold b°C; turning on the heat exchange module when the indoor AQI satisfies a preset condition, i.e., the AQI is greater than a preset threshold c; and turning on the fresh air module when the indoor AQI does not satisfy the preset condition, i.e., the AQI is less than or equal to the preset threshold c.

At step S20, the target module is turned off, and the refrigeration module is turned on, and a second operating power of the temperature control system is obtained in response to the air outlet temperature being equal to the preset temperature threshold.

Optionally, after turning off the target module, the refrigeration module is turned, and a refrigeration power of the refrigeration module is adjusted. The second operating power of the current operation of the temperature control system is obtained in response to the air outlet temperature being equal to the preset temperature threshold again. The second operating power is an operating power of the refrigeration module.

At step S30, operation of the target module and the refrigeration module is controlled based on the first operating power and the second operating power.

Optionally, the first operating power and the second operating power are compared to each other. The refrigeration module is controlled to continue operating in response to the first operating power being greater than or equal to the second operating power. The refrigeration module is turned off and the target module is turned on in response to the first operating power being less than the second operating power, in which the target module operates at the first operating power.

Optionally, the refrigeration module is controlled to continue operating in response to a difference between the first operating power and the second operating power being greater than a preset difference threshold, and the first operating power being greater than or equal to the second operating power. The refrigeration module is turned off and the target module is turned on in response to the difference between the first operating power and the second operating power being greater than the preset difference threshold, and the first operating power being less than the second operating power. In response to the difference between the first operating power and the second operating power being less than the preset difference threshold, the refrigeration module is controlled to continue operating to avoid frequent switching between the temperature control modules, which may lead to an unstable environmental temperature in the equipment compartment.

In the technical solution of the embodiments, by obtaining the first operating power of the temperature control system when the target module operates, and the second operating power when the refrigeration module operates, and comparing the first operating power and the second operating power, the operation of the target module and the refrigeration module is controlled based on the comparison result. Thus, the temperature control of the equipment compartment is realized, and the energy consumption of the temperature control system is reduced.

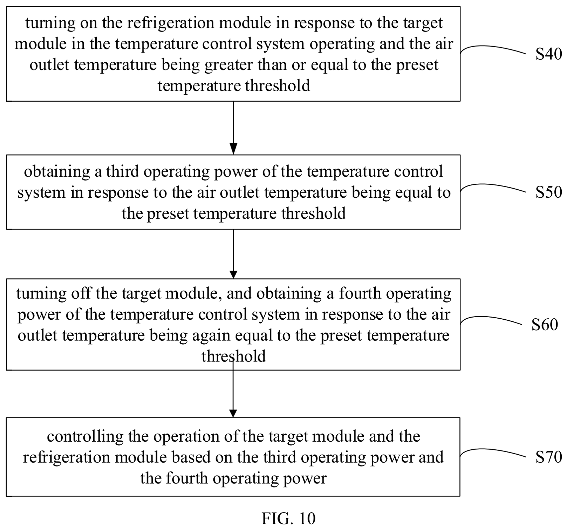

Referring to FIG. 10, it is a second embodiment of a method for temperature control of an outdoor cabinet of the disclosure. Based on the first embodiment, the method includes the following steps.

At step S40, a refrigeration module is turned on in response to a target module in a temperature control system operating and an air outlet temperature being greater than or equal to a preset temperature threshold.

At step S50, a third operating power of the temperature control system is obtained in response to the air outlet temperature being equal to the preset temperature threshold.

At step S60, the target module is turned off, and a fourth operating power of the temperature control system is obtained in response to the air outlet temperature being again equal to the preset temperature threshold.

At step S70, the operation of the target module and the refrigeration module is controlled based on the third operating power and the fourth operating power.

Optionally, the target module may be a fresh air module or a heat exchange module.

Optionally, the refrigeration module is turned on when the target module in the temperature control system operates and the air outlet temperature is greater than or equal to the preset temperature threshold. At this time, both the target module and the refrigeration module operate. The third operating power of the temperature control system is obtained when the air outlet temperature is equal to the preset temperature threshold. The third operating power is an operating power when both the target module and the refrigeration module operate.

Optionally, the target module is turned off, and the refrigeration module is still operating. The fourth operating power of the temperature control system is obtained when the air outlet temperature is again equal to the preset temperature threshold. The fourth operating power is an operating power when the refrigeration module operates alone.

Optionally, the third operating power and the fourth operating power are compared to each other. Both the target module and the refrigeration module are turned on in response to the third operating power being less than the fourth operating power. The refrigeration module is controlled to continue operating in response to the third operating power being greater than or equal to the fourth operating power.

Optionally, the refrigeration module is controlled to continue operating when a difference between the third operating power and the fourth operating power is greater than a preset difference threshold, and the third operating power is greater than or equal to the fourth operating power. Both the target module and the refrigeration module are turned on when the difference between the third operating power and the fourth operating power is greater than the preset difference threshold, and the third operating power is less than the fourth operating power. When the difference between the third operating power and the fourth operating power is less than the preset difference threshold, the refrigeration module is controlled to continue operating, to avoid frequent switching between the temperature control modules, which may lead to an unstable environmental temperature in the equipment compartment.

In the technical solution of the embodiments, by obtaining the third operating power of the temperature control system when the target module and the refrigeration module operate, and the fourth operating power when the refrigeration module operates, and comparing the third operating power and the fourth operating power, the operation of the target module and the refrigeration module is controlled based on the comparison result. Thus, the temperature control of the equipment compartment is realized, and the energy consumption of the temperature control system is reduced.

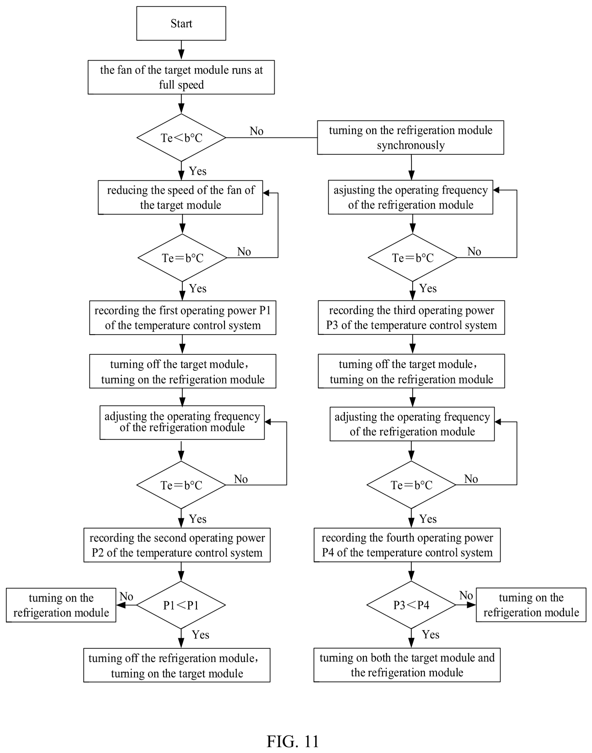

In an embodiment, referring to FIG. 11, the fan of the target module runs at full speed at the beginning, and the air outlet temperature of the equipment compartment may be further determined. When the air outlet temperature of the equipment compartment is less than an upper temperature limit set by the system, i.e., *Te<b°*C*,* the speed of fan of the target module may be continuously reduced until *Te=b°C,* to reach the heat balance, and the power P1 of the temperature control system in this mode is recorded. The target module is turned off, the refrigeration module is turned on, and an operating frequency of the refrigeration module is adjusted until *Te=b°C,* and the power P2 of the temperature control system in this mode is recorded. The power consumption of the temperature control system is determined, if P1 < P2, the target module needs to be turned on; if P1 > P2, the refrigeration module needs to be turned on.

When the air outlet temperature of the equipment compartment is greater than the upper temperature limit set by the system, i.e., *Te>b°*C*,* the refrigeration module is turned on synchronously. The operating frequency of the refrigeration module is continuously adjusted until *Te=b°C,* to reach a stable operating condition, and the power P3 of the temperature control system in this mode is recorded. The target module is turned off, and only the refrigeration module is turned on, and the operating frequency of the refrigeration module is adjusted until *Te=b°C,* and the power P4 of the temperature control system in this mode is recorded. The power consumption of the temperature control system is determined, if P3 < P4, both the target module and the refrigeration module may be turned on; if P3 > P4, the refrigeration module may be turned on.

A computer-readable storage medium is also provided in the disclosure. The computer-readable storage medium stores a program for temperature control of an outdoor cabinet that, when executed by a processor, implements steps of the method for temperature control of an outdoor cabinet described in the above embodiments.

The above serial numbers of embodiments of the disclosure are for descriptive purposes only and do not represent the merits of the embodiments.

It should be noted that, the terms "include/including", "contain/containing" or any other variations thereof, are intended to cover a non-exclusive inclusion, such that a process, a system, an article or an apparatus including a series of elements not only includes those elements but also includes other elements not expressly listed, or may also include elements inherent to such process, system, article, or apparatus. In the absence of further limitation, the element defined by a sentence "including one" do not exclude the presence of additional same elements in the process, system, article, or apparatus that includes the elements.

Through the description of the implementations above, those skilled in the art can clearly understand that the aforementioned system can be realized by utilizing software along with the necessary general hardware platform. It can also be implemented purely through hardware. However, in many cases, the former is a preferred approach. On the basis of such an understanding, the technical solution of the present disclosure essentially or partly contributing to the prior art, or part of the technical solution may be embodied in the form of a software product, which is stored in the computer-readable storage medium described above (e.g., ROM/RAM, disk, CD-ROM), including several instructions configured to enable a terminal device (which may be a cell phone, a computer, a parking management device, an air conditioner, or a network device, etc.) to perform the system described in various embodiments of the disclosure.

The above is only preferred embodiments of the disclosure and does not limit the scope of the disclosure. Any equivalent structures or processes that are derived from the content of the description and accompanying drawings of the disclosure, or that are applied directly or indirectly in other related technical fields, are similarly included within the protection scope of the present invention.

## Claims

1. A method for temperature control of an outdoor cabinet, comprising:
reducing a rotational speed of a fan in a target module in a temperature control system in response to the target module in the temperature control system operating and an air outlet temperature of an equipment compartment satisfying a first preset condition, and obtaining a first operating power of the temperature control system in response to the air outlet temperature satisfying a second preset condition;
turning off the target module and turning on a refrigeration module, and obtaining a second operating power of the temperature control system in response to the air outlet temperature satisfying a second preset condition; and
controlling operation of the target module and the refrigeration module based on the first operating power and the second operating power.

2. The system according to claim 1, wherein the first preset condition is that the air outlet temperature of the equipment compartment is less than a preset temperature threshold; wherein the second preset condition is that the air outlet temperature of the equipment compartment is equal to the preset temperature threshold.

3. The method according to claim 1 or claim 2, wherein controlling the operation of the target module and the refrigeration module based on the first operating power and the second operating power comprises:
controlling the refrigeration module to continue operating in response to the first operating power being greater than or equal to the second operating power; and
turning off the refrigeration module and turning on the target module in response to the first operating power being less than the second operating power.

4. The method according to any one of claims 1 to 3, further comprising:
turning on the refrigeration module in response to the target module in the temperature control system operating and the air outlet temperature not satisfying the first preset condition;
obtaining a third operating power of the temperature control system in response to the air outlet temperature satisfying the second preset condition;
turning off the target module, and obtaining a fourth operating power of the temperature control system in response to the air outlet temperature again satisfying the second preset condition; and
controlling the operation of the target module and the refrigeration module based on the third operating power and the fourth operating power.

5. The method according to claim 4, wherein controlling the operation of the target module and the refrigeration module based on the third operating power and the fourth operating power comprises:
turning on both the target module and the refrigeration module in response to the third operating power being less than the fourth operating power; and
controlling the refrigeration module to continue operating in response to the third operating power being greater than or equal to the fourth operating power.

6. A system for temperature control of an outdoor cabinet, comprising:
an equipment compartment; and
a temperature control compartment, wherein the temperature control compartment comprises a control module and a temperature control module, wherein the control module is configured to control operation of the temperature control module based on a power of the temperature control module, and the temperature control module comprises a refrigeration module, a fresh air module, a heat exchange module and a heating module;
wherein the control module comprises a processor, a memory, and a program for temperature control of an outdoor cabinet executable by the processor stored on the memory, wherein when the program is executed by the processor, steps of the method according to any one of claims 1 to 5 are implemented.

7. The system according to claim 6, wherein the refrigeration module, the fresh air module, the heat exchange module and the heating module are arranged at intervals, and each in the temperature control module is connected to the equipment compartment respectively.

8. The system according to any one of claims 6 to 7, wherein the refrigeration module comprises an outdoor unit and an indoor unit arranged independently with each other, wherein an air inlet and an air outlet of the indoor unit are connected to the equipment compartment, and an air inlet and an air outlet of the outdoor unit are connected to external environment.

9. The system according to any one of claims 6 to 8, wherein the fresh air module comprises a first air inlet compartment and a first air outlet compartment arranged independently, wherein an air inlet of the first air inlet compartment is connected to external environment and is equipped with an air inlet fan, and an air outlet of the first air inlet compartment is connected to the equipment compartment; wherein an air inlet of the first air outlet compartment is connected to the equipment compartment, and an air outlet of the first air outlet compartment is connected to the external environment and is equipped with an air outlet fan.

10. The system according to any one of claims 6 to 9, wherein the heat exchange module comprises a second air inlet compartment and a second air outlet compartment, wherein a heat exchanger is arranged between the second air inlet compartment and the second air outlet compartment, an air inlet and an air outlet of the second air inlet compartment are connected to the equipment compartment respectively, and an air inlet and an air outlet of the second air outlet compartment are connected to external environment.

11. The system according to any one of claims 6 to 10, wherein the heating module comprises a third air inlet compartment and a third air outlet compartment, wherein an electric heater is arranged between the third air inlet compartment and the third air outlet compartment; the third air inlet compartment is equipped with an air inlet fan, and an air inlet of the third air inlet compartment is connected to the equipment compartment; wherein an air outlet of the third air outlet compartment is connected to the equipment compartment, and the third air outlet compartment is equipped with an air outlet fan.

12. The system according to any one of claims 6 to 11, further comprising:
an equipment temperature monitoring module, configured to monitor an air outlet temperature of the equipment compartment.

13. The system according to any one of claims 6 to 12, further comprising:
an outdoor temperature monitoring module, configured to monitor an outdoor air temperature.

14. The system according to any one of claims 6 to 13, further comprising:
an air quality monitoring module, configured to monitor an outdoor air quality.

15. A computer-readable storage medium storing a program for temperature control of an outdoor cabinet that, when executed by a processor, implements steps of the method according to any one of claims 1 to 5.
